# EUROPÄISCHE PATENTSCHRIFT

(11) **EP 1 295 971 B1**
(45) Veröffentlichungstag und Bekanntmachung des Hinweises auf die Patenterteilung: **11.04.2007**
(21) Anmeldenummer: 02020106.7
(22) Anmeldetag: 07.09.2002
(51) Int. Cl.: C30B 29/16, H01L 39/24, C04B 35/00

(54) **Trägermaterial auf Nickelbasis und Verfahren zu dessen Herstellung**
Nickel based supporting material and process for its manufacture
Matériau de support à base de nickel et procédé pour sa fabrication

(30) Priorität: 21.09.2001 DE 10148889
(43) Veröffentlichungstag der Anmeldung: 26.03.2003
(73) Patentinhaber: Leibniz-Institut für Festkörper- und Werkstoffforschung Dresden e.V., 01069 Dresden (DE)
(72) Erfinder: Selbmann, Dietmar, 01738 Colmnitz (DE); Eickenmeyer, Jörg, 01279 Dresden (DE); Opitz, Ralph, 01108 Dresden (DE)
(74) Vertreter: Rauschenbach, Dieter

(56) Entgegenhaltungen:
- EP-A- 0 884 787
- DE-A1- 10 005 861
- US-A- 5 968 877
- MATSUMOTO K ET AL: "Fabrication of In-Plane Aligned YBCO Films on Polycrystalline Ni Tapes Buffered with Surface-Oxidized NiO layers" IEEE TRANSACTIONS ON APPLIED SUPERCONDUCTIVITY, Bd. 9, Nr. 2, Juni 1999 (1999-06), Seiten 1539-1542, XP011005509
- WATANABE T ET AL: "Long length oxide template for YBCO coated conductor prepared by surface-oxidation epitaxy method" PHYSICA C, NORTH-HOLLAND PUBLISHING, AMSTERDAM, NL, Bd. 357-360, August 2001 (2001-08), Seiten 914-922, XP004274352 ISSN: 0921-4534
- SUN E Y ET AL: "High-resolution transmission electron microscopy/analytical electron microscopy characterization of epitaxial oxide multilayers fabricated by laser ablation on biaxially textured Ni" PHYSICA C, NORTH-HOLLAND PUBLISHING, AMSTERDAM, NL, Bd. 321, Nr. 1-2, 1. August 1999 (1999-08-01), Seiten 29-38, XP004182870 ISSN: 0921-4534

## Beschreibung

Die Erfindung betrifft Trägermaterial auf Nickelbasis, bestehend aus einem texturierten, vorzugsweise bandförmigem Halbzeug aus einem Nickelbasis-Werkstoff, das mit einer Nickeloxidschicht für physikalisch-chemische Beschichtungen mit hochgradiger mikrostruktureller Ausrichtung versehen ist, sowie ein Verfahren zu dessen Herstellung.

Das Trägermaterial ist insbesondere für die Herstellung von bandförmigen Hochtemperatur-Supraleitern geeignet.

Als Trägermaterial für die Herstellung von supraleitenden Schichten werden reine, mikrolegierte und legierte texturierte Ni-Substrate verwendet. Dabei werden aufgrund der chemischen Wechselwirkungen zwischen Ni und dem Supraleiterwerkstoff, z.B. YBa₂Cu₃O₇₋ₓ, die die supraleitenden Eigenschaften zerstören, Zwischenschichten benötigt. Diese Zwischenschichten dienen als Diffusionsbarriere und als Basis für die nachfolgende Aufbringung hochtexturierter Supraleiterschichten. Für die Zwischenschicht werden vorzugsweise Yttrium stabilisiertes Zirkonoxid (YSZ) und Ceroxid verwendet.

Hohe Stromdichten lassen sich nur in hochtexturierten Supraleiterschichten erreichen, bei denen die Korngrenzenwinkel < 10° sind, so dass insbesondere bei der Anwendung von Vielfachschichtsystemen neben der Eignung der Zwischenschichten als Diffusionsbarriere und Texturbasis ihre Struktur wie Korngröße und Habitus sowie die Oberflächenrauhigkeit eine dominierende Rolle spielen.

Zur Herstellung hochtexturierter biaxial orientierter Zwischenschichten sind verschiedene Verfahrenswege bekannt.

Einer dieser Verfahrenswege besteht darin, dass man hochtexturierte und dichte YSZ-Zwischenschichten mittels IBAD-Verfahren (Ion Beam Assisted Deposition) auf dem Trägermaterial abscheidet (V. Betz, B. Holzapfel, G. Sipos, W. Schmidt, N. Mattern, L. Schultz, Inst. Phys. Conf. Ser. No. 158, (1997) 1081). Auf den so erzeugten Zwischenschichten lassen sich dann YBCO-Supraleiterschichten mit hohen kritischen Stromdichten von 2 MA/cm² abscheiden. Die Nachteile dieses Verfahrens zur Erzeugung von Zwischenschichten bestehen in den niedrigen Abscheidungsraten und in der teuren Anlagentechnik, so dass insbesondere für die Herstellung langer supraleitender Bänder (> 1 m), wie sie in der Energietechnik benötigt werden, die Kosten zu hoch sind.

Ein anderer Verfahrensweg zur Erzeugung von Zwischenschichten besteht darin, dass man auf biaxial texturierten Trägermaterialien, z.B. Ni-RABiTS (Rolling Assisted Biaxially Textured Substrates), durch epitaktisches Schichtwachstum mittels physikalischer oder chemischer Abscheidungsmethoden hochtexturierte Zwischenschichten herstellt. Als physikalische Abscheidungsmethode kann beispielsweise das thermische Verdampfen angewandt werden, das jedoch sehr kostenintensiv ist (J. Knauf, R. Semerad, W. Prusseit, B. de Boer, J. Eickemeyer, IEEE Trans. Appl. Supercond., 11 (2001) 1, 2885-2888).

Als chemische Abscheidungsmethode kommt insbesondere das Verfahren der MO CVD in Betracht (D. Selbmann, M. Krellmann, A. Leonhardt, J. Eickemeyer, J. Phys. IV France 10 (2000), Pr2/27-33; F. Weiss, U. Schmatz, J.-P. Senateur, K. Fröhlich, D. Machjdik, D. Selbmann, M. Krellmann, Applied Superconductivity 1995, IOP 148, 919-922). Allerdings besteht hierbei - wie auch bei den anderen bekannten Beschichtungsverfahren - die Gefahr der unkontrollierten und unerwünschten Oxidation der Ni-Oberfläche. Das so gebildete NiO ist regellos orientiert und verhindert die epitaktische Abscheidung der Zwischenschicht.

Zur Vermeidung dieser unerwünschten Effekte sind bisher zwei Verfahrensvarianten bekannt.

Eine der Verfahrensvarianten besteht darin, dass in der Anfangsphase des Beschichtungsprozesses zunächst eine dünne Metallschicht von einigen nm Dicke in Wasserstoff abgeschieden wird und dass nach der Abscheidung dieser Schicht die Gasatmosphäre gewechselt und Sauerstoff für den weiteren Schichtbildungsprozess verwendet wird (J. Knauf, R. Semerad, W. Prusseit, B. de Boer, J. Eickemeyer, IEEE Trans. Appl. Supercond., 11 (2001) 1, 2885-2888).

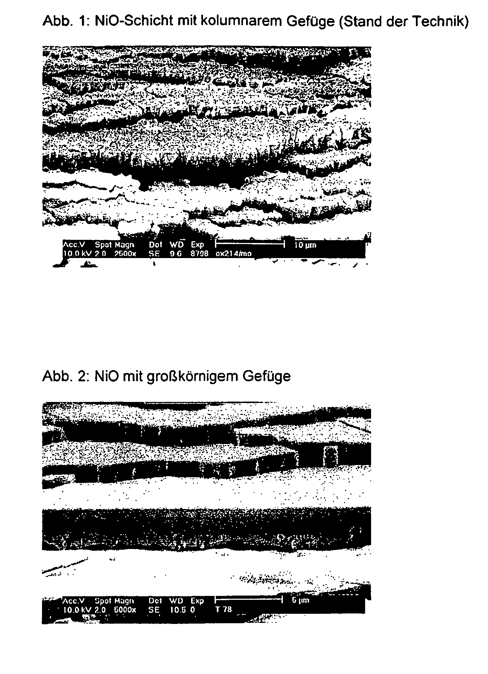

Bei der anderen Verfahrensvariante erfolgt die Herstellung von texturiertem NiO auf texturierten Ni-Substraten durch kontrollierte Oxidation in Sauerstoff oder Luft bei Temperaturen zwischen 700 °C und 1200 °C (K. Matsumoto, Y. Niiori, I. Hirabayashi, N. Koshizuka, T. Watanabe, Y. Tanaka, M. Ikeda, 10^{th} International Symposium on Superconductivity, Gitu, Japan, October 27-33, 1997). Die NiO-Schichten wachsen dabei epitaktisch und haben eine Texturschärfe in der Größenordnung des Substrates. Nachteilig hierbei ist jedoch, dass diese NiO-Schichten ein kolumnares Gefüge mit Korngrößen in der Größenordnung von (1 x 1) µm² haben, wie dies aus Abb.1 ersichtlich ist.

Dieser kolumnare Schichtaufbau verursacht rauhe Schichtoberflächen mit mittlere Rauhigkeiten Rₐ um 450 nm, wodurch insbesondere bei Schichtdicken > 1 µm die weitere epitaktische Schichtabscheidung erschwert sowie auf Grund der großen Anzahl der Korngrenzen die Ni-Diffusion in die Folgeschichten nicht vollständig verhindert wird.

Der Erfindung liegt die Aufgabe zugrunde, ein Trägermaterial auf Nickelbasis zu schaffen, das aus einem Halbzeug aus einem Nickelbasis-Werkstoff mit einer darauf vorhandenen Nickeloxidschicht besteht, die als hochwirksame Diffusionsbarriere dient und die ein hochgradig mikrostrukturell ausgerichtetes Gefüge in nachfolgend epitaktisch abgeschiedenen Schichten bewirkt. Eingeschlossen in diese Aufgabe ist die Schaffung eines Verfahrens zur Herstellung eines solchen Trägermaterials.

Diese Aufgabe ist nach der Erfindung mit einem Trägermaterial gelöst, bei dem die Nickeloxidschicht in der Schichtausdehnung zu 90 bis 100% ein Gefüge aufweist, das exakt nach (100) orientiert ist und das aus einem Einkristall oder aus großen Körnern mit einer Korngröße von mindestens 20 µm besteht.

Hierbei kann die Nickeloxidschicht in der Schichtausdehnung zu 0 bis 10% ein polykristallines, kolumnar ausgerichtetes Gefüge aufweisen.

Vorteilhaft ist es, wenn die Nickeloxidschicht eine Mittenrauhigkeit Rₐ von < 50 nm hat.

Vorzugsweise besitzen die großen Körner eine Korngröße im Bereich von 20 µm bis 200 µm. Die Körner können jedoch auch bis zu 20 cm groß sein.

Zweckmäßigerweise weist die Nickeloxidschicht eine Dicke im Bereich von 0,1 µm bis 10 µm auf.

Zur Herstellung des erfindungsgemäßen Trägermaterials wird ein texturiertes Halbzeug aus einem Nickelbasis-Werkstoff einer Oxidation in einer O₂-haltigen Atmosphäre bei Temperaturen im Bereich von 1000°C bis 1200 °C unterworfen, wobei nach der Erfindung als Ausgangsmaterial ein texturiertes Halbzeug mit einer lateralen Orientierung von < 10°, einer Korngröße im Bereich von 5 um bis 50µm und einer Oberflächenrauhigkeit von < 20 nm verwendet wird und bei der Oxidation ein Oxidationsstart unterhalb von 1000°C durch eine rasche Aufheizung vermieden wird.

Eine Möglichkeit zur Vermeidung des Oxidationsstartes unterhalb von 1000°C besteht darin, dass das Ausgangsmaterial mit einer Aufheizrate von mindestens 200 K/s von Raumtemperatur bis auf 1000°C rasch aufgeheizt wird.

Vorteilhaft ist es, wenn das oxidierte Halbzeug am Ende des Oxidationsvorganges mit einer Abkühlrate von mindestens 100 K/s bis auf eine Temperatur von 600°C rasch abgekühlt wird.

Das Halbzeug kann in reinem Sauerstoff oder in sauerstoffhaltigen Gasgemischen oxidiert werden.

Der Oxidationsprozess kann zweckmäßig während einer Dauer im Bereich von 1 min bis 10 min durchgeführt werden.

Das Verfahren kann vorteilhaft als kontinuierlicher Prozess ausgeführt werden, insbesondere bei der Herstellung von bandförmigem Trägermaterial.

Nachstehend ist die Erfindung anhand von Ausführungsbeispielen näher erläutert.

### Beispiel 1

Ein Ni-Trägermaterial, das mit 0,1 Atom-% Mo mikrolegiert und das ein Gefüge mit einer {100}〈001〉 Würfeltextur mit einer Halbwertsbreite von 8,8° und einer Korngröße von 45 µm aufweist, wird einem kurzen Reinigungsprozess von 10 min in Wasserstoff bei einer Temperatur von 800°C in einem Quarzrohr, das in einen konventionellen widerstandsbeheizten Ofen angeordnet ist, unterzogen. Diese Behandlung dient zum Entfernen der durch die Lagerung an Luft gebildeten NiO-Schicht.

Nach der Abkühlung des Trägermaterials auf etwa Raumtemperatur wird im Quarzrohr ein Gaswechsel von Wasserstoff zu reinem Sauerstoff unter Anwendung einer Zwischenspülung mit Argon durchgeführt. Anschließend wird das Quarzrohr auf eine Temperatur von 1150°C aufgeheizt, wobei das Trägermaterial im Quarzrohr außerhalb der Heizzone des Ofens angeordnet ist. Unmittelbar nach dem Erreichen der Temperatur von 1150°C wird das Trägermaterial im Quarzrohr rasch in den Bereich der Heizzone des Ofens geschoben und dort im Sauerstoff bei Normaldruck oxidiert. Nach einer Verweilzeit von 5 min wird das Trägermaterial rasch aus der Heizzone gezogen und abgekühlt. Der Abkühlvorgang erfolgt unter Argon mit einer Abkühlgeschwindigkeit von ca. 100 K/sec bis zu einer Temperatur von 600°C und weiter mit 100 K/min bis auf Raumtemperatur.

Die so auf dem Trägermaterial gebildete NiO-Schicht hat eine Schichtdicke von 2 µm. Das Gefüge besteht aus großen Körnern, mit einem geringen Anteil von kolumnaren Gefüge von ca. 10% der NiO-Oberfläche wie dies aus Abb. 2 ersichtlich ist.

Die mittleren Rauhigkeit Rₐ auf den großen Körnern ist kleiner 40 nm. Die biaxiale Textur wurde mit einer Halbwertsbreite von 8,2° bestimmt.

Auf dieser NiO-Schicht wurde mittels MO CVD eine YSZ-Schicht bei 650°C und anschließend eine Y₂O₃-Schicht bei 600°C abgeschieden. Die Güte der epitaktischen Schichtabscheidung wurde mittels Messungen der (111)-Polfiguren von Substrat, NiO und der CVD-Schichten ermittelt. Die Abweichung der Halbwertsbreiten zwischen Substrat und der Y₂O₃-Deckschicht beträgt nur ca. 1°. Das zeigt die Eignung der erfindungsgemäßen großkörnigen NiO-Schicht als Epitaxiebasis für die weitere Abscheidung von oxidischen Schichten.

### Beispiel 2

Ein Ni-Trägermaterial, das mit 5 Atom-% W legiert ist und das ein Gefüge mit einer biaxialen Textur mit einer Halbwertsbreite von 4° und einer Korngröße von 22 µm aufweist und dessen Oberfläche eine mittleren Rauhigkeit Rₐ von 18 nm hat, wird einem Reinigungsprozess analog wie im Beispiel 1 beschrieben unterzogen.

Danach wird ein Oxidationsprozess bei einer Temperatur von 1025°C in einem Stickstoff-Sauerstoff-Gemisch mit einem Volumenverhältnis von 4:1 bei Atmosphärendruck für 2 Minuten durchgeführt. Die Prozessführung entspricht dem im Beispiel 1 beschriebenen Verfahren.

Die auf dem Trägermaterial erhaltene NiO-Schicht hat eine Dicke von 0,7 µm und eine scharfe biaxiale Textur mit einer Halbwertsbreite von 4,7°. Der Anteil der kolumnaren Gefüges beträgt nur 7%. Die mittlere Rauhigkeit Rₐ ist kleiner 32 nm.

Diese NiO-Schicht eignet sich in gleich guter Weise wie die NiO-Schicht gemäß Beispiel 1 als Epitaxiebasis für die weitere Abscheidung von oxidischen Schichten.

## Patentansprüche

1. Trägermaterial auf Nickelbasis, bestehend aus einem texturierten Halbzeug aus einem Nickelbasis-Werkstoff, das mit einer Nickeloxidschicht für physikalischchemische Beschichtungen mit hochgradiger mikrostruktureller Ausrichtung versehen ist, insbesondere für die Herstellung von Hochtemperatur-Supraleitern, **dadurch gekennzeichnet, dass** die Nickeloxidschicht in der Schichtausdehnung zu 90 bis 100% ein Gefüge aufweist, das exakt nach (100) orientiert ist und das aus einem Einkristall oder aus großen Körnern mit einer Korngröße von mindestens 20 µm besteht.

2. Trägermaterial nach Anspruch 1, **dadurch gekennzeichnet, dass** die Nickeloxidschicht in der Schichtausdehnung zu 0 bis 10% ein polykristallines, kolumnar ausgerichtetes Gefüge aufweist.

3. Trägermaterial nach Anspruch 1, **dadurch gekennzeichnet, dass** die Nickeloxidschicht eine mittlere Rauhigkeit Rₐ von < 50 nm hat.

4. Trägermaterial nach Anspruch 1, **dadurch gekennzeichnet, dass** die großen Körner eine Korngröße im Bereich von 20 µm bis 200 µm besitzen.

5. Trägermaterial nach Anspruch 1, **dadurch gekennzeichnet, dass** die Nickeloxidschicht 0,1 µm bis 10 µm dick ist.

6. Verfahren zur Herstellung eines Trägermaterials nach Anspruch 1, bei dem ein texturiertes Halbzeug aus einem Nickelbasis-Werkstoff einer Oxidation in einer O₂-haltigen Atmosphäre bei Temperaturen im Bereich von 1000°C bis 1200 °C unterworfen wird, **dadurch gekennzeichnet, dass** als Ausgangsmaterial ein texturiertes Halbzeug mit einer in-plane-Orientierung von < 10°, einer Korngröße im Bereich von 5 µm bis 50µm und einer mittleren Rauhigkeit Rₐ von < 20 nm verwendet wird, und dass bei der Oxidation ein Oxidationsstart unterhalb von 1000°C durch eine rasche Aufheizung vermieden wird.

7. Verfahren nach Anspruch 6, **dadurch gekennzeichnet, dass** das Ausgangsmaterial mit einer Aufheizrate von mindestens 200 K/s von Raumtemperatur bis auf 1000°C rasch aufgeheizt wird.

8. Verfahren nach Anspruch 6, **dadurch gekennzeichnet, dass** das oxidierte Halbzeug am Ende des Oxidationsvorganges mit einer Abkühlrate von mindestens 100 K/s bis auf eine Temperatur von 600°C rasch abgekühlt wird.

9. Verfahren nach Anspruch 6, **dadurch gekennzeichnet, dass** das Halbzeug in reinem Sauerstoff oder in sauerstoffhaltigen Gasgemischen oxidiert wird, und dass der Oxidationsprozess während einer Dauer im Bereich von 1 min bis 10 min durchgeführt wird.

10. Verfahren nach Anspruch 6, **dadurch gekennzeichnet, dass** dieses als kontinuierlicher Prozess ausgeführt wird, insbesondere bei der Herstellung von bandförmigem Trägermaterial.

## Claims

1. Nickel-based support material, consisting of a textured semifinished product made of a nickel-based material which is provided with a nickel oxide layer for physicochemical coatings with high-grade microstructural alignment, in particular for the production of high-temperature superconductors, **characterized in that** from 90 to 100% of the nickel oxide layer in the layer extent comprises a structure which is oriented exactly along (100) and which consists of a single crystal or large grains with a grain size of at least 20 µm.

2. Support material according to Claim 1, **characterized in that** from 0 to 10% of the nickel oxide layer in the layer extent comprises a polycrystalline, columnarly aligned structure.

3. Support material according to Claim 1, **characterized in that** the nickel oxide layer has an average roughness Rₐ of < 50 nm.

4. Support material according to Claim 1, **characterized in that** the large grains have a grain size in the range of from 20 µm to 200 µm.

5. Support material according to Claim 1, **characterized in that** the nickel oxide layer is from 0.1 µm to 10 µm thick.

6. Method for producing a support material according to Claim 1, in which a textured semifinished product made of a nickel-based material is subjected to oxidation in an atmosphere containing O₂ at temperatures in the range of from 1000°C to 1200°C, **characterized in that** a textured semifinished product with an in-plane orientation of < 10°, a grain size in the range of from 5 µm to 50 µm and an average roughness Rₐ of < 20 nm is used as the starting material, and **in that** an oxidation start below 1000°C is avoided by rapid heating during the oxidation.

7. Method according to Claim 6, **characterized in that** the starting material is heated rapidly from room temperature to 1000°C with a heating rate of at least 200 K/s.

8. Method according to Claim 6, **characterized in that** the oxidized semifinished product is cooled rapidly to a temperature of 600°C with a cooling rate of at least 100 K/s at the end of the oxidation process.

9. Method according to Claim 6, **characterized in that** the semifinished product is oxidized in pure oxygen or in gas mixtures containing oxygen, and **in that** the oxidation process is carried out for a duration in the range of from 1 min to 10 min.

10. Method according to Claim 6, **characterized in that** it is carried out as a continuous process, in particular for the production of a strip-shaped support material.

## Revendications

1. Matériau de support à base de nickel, constitué d'une ébauche texturée en un matériau à base de nickel qui est dotée d'une couche d'oxyde de nickel pour revêtement physico-chimique à microstructure fortement orientée, en particulier pour la préparation de supraconducteurs à haute température, **caractérisé en ce que** la couche d'oxyde de nickel présente dans jusque 90 à 100 % de son extension un réseau orienté exactement suivant (100) et est constituée d'un monocristal ou de grands cristaux dont la taille est d'au moins 20 µm.

2. Matériau de support selon la revendication 1, **caractérisé en ce que** la couche d'oxyde de nickel présente dans 0 à 10 % de son extension un réseau polycristallin à orientation tabulaire.

3. Matériau de support selon la revendication 1, **caractérisé en ce que** la couche d'oxyde de nickel a une rugosité moyenne Rₐ de < 50 nm.

4. Matériau selon la revendication 1, **caractérisé en ce que** les grands grains ont une taille comprise entre 20 µm et 200 µm.

5. Matériau de support selon la revendication 1, **caractérisé en ce que** la couche d'oxyde de nickel a une épaisseur comprise entre 0,1 µm et 10 µm.

6. Procédé de préparation d'un matériau de support selon la revendication 1, dans lequel une ébauche texturée en un matériau à base de nickel subit à une température comprise dans la plage de 1 000° C à 1 200° C une oxydation dans une atmosphère qui contient de l'O₂, **caractérisé en ce que** comme matériau de départ, on utilise une ébauche texturée dont l'orientation dans le plan est < 10°, dont la granulométrie est comprise entre 5 µm et 50 µm et dont la rugosité moyenne Rₐ est < 20 nm et **en ce que** lors de l'oxydation, on évite un début d'oxydation en dessous de 1 000° C par une montée rapide en température.

7. Procédé selon la revendication 6, **caractérisé en ce que** le matériau de départ est chauffé rapidement depuis la température ambiante jusqu'à 1 000° C à une vitesse de montée en température d'au moins 200 K/s.

8. Procédé selon la revendication 6, **caractérisé en ce qu'**à la fin de l'opération d'oxydation, l'ébauche oxydée est refroidie rapidement à une vitesse de refroidissement d'au moins 100 K/s jusqu'à une température de 600° C.

9. Procédé selon la revendication 6, **caractérisé en ce que** l'ébauche est oxydée dans l'oxygène pur ou dans un mélange qui contient de l'oxygène et **en ce que** l'opération d'oxydation est réalisée pendant une durée comprise entre 1 min et 10 min.

10. Procédé selon la revendication 6, **caractérisé en ce qu'**il est mis en oeuvre sous la forme d'une opération continue, en particulier lors de la fabrication d'un matériau de support en forme de bande.
